# EUROPEAN PATENT SPECIFICATION

(11) **EP 2 213 762 B1**
(45) Date of publication and mention of the grant of the patent: **22.05.2019**
(21) Application number: 09252843.9
(22) Date of filing: 21.12.2009
(51) Int. Cl.: C23C 14/30, C23C 14/24, C23C 14/22

(54) **COATING DEVICE AND DEPOSITION APPARATUS**
BESCHICHTUNGSVORRICHTUNG UND ABLAGERUNGSVORRICHTUNG
DISPOSITIF DE REVÊTEMENT ET APPAREIL DE DÉPÔT

(30) Priority: 28.01.2009 US 360966
(43) Date of publication of application: 04.08.2010
(73) Proprietor: United Technologies Corporation, Farmington, CT 06032 (US)
(72) Inventor: Neal, James W., Ellington, CT 06029 (US); Litton, David A., West Hartford, CT 06107 (US); Maloney, Michael J., Marlborough, CT 06447 (US); Masucci, Christopher, Coventry, CT 06238 (US)
(74) Representative: Dehns

(56) References cited:
- US-A1- 2004 118 347
- US-A1- 2005 000 444
- US-A1- 2008 220 177

## Description

### BACKGROUND OF THE INVENTION

This disclosure relates to coating equipment and, more particularly, to a coating device and deposition apparatus that facilitates depositing a coating material on surfaces of a substrate.

Physical vapor deposition ("PVD") is one common method for coating a substrate, such as gas turbine engine airfoils. For instance, the coating may be a protective coating or a coating for promoting adhesion. One type of PVD process utilizes an electron beam gun to melt and vaporize a source material in a crucible. The vaporized source material deposits onto the substrate. Although effective, angled surfaces and non-line-of-sight surfaces relative to the crucible may be poorly coated or not coated at all.

A coating device having the features of the preamble of claim 1 is disclosed in US 2008/0220177 A1.

### SUMMARY OF THE INVENTION

From a first aspect, the present invention provides a coating device for use with an electron beam vapor deposition apparatus, as set forth in claim 1.

The coating device may be part of an electron beam vapor deposition apparatus that includes a coating chamber, a coating zone within the coating chamber for coating work pieces, at least one electron beam source for evaporating a source coating material, and a gas source for selectively providing a carrier gas to the coating device.

From a further aspect, the present invention provides a method for use with an electron beam vapor deposition apparatus, as set forth in claim 6.

### BRIEF DESCRIPTION OF THE DRAWINGS

The various features and advantages of the disclosed examples will become apparent to those skilled in the art from the following detailed description. The drawings that accompany the detailed description can be briefly described as follows.
Figure 1 illustrates selected portions of an example deposition apparatus.
Figure 2 illustrates an example of a coating device for use with the deposition apparatus, but which falls outside the scope of the claims.
Figure 3 illustrates an example of the operation of the coating device.
Figure 4 illustrates an example coating device for use with the deposition apparatus, and which falls within the scope of the claims.
Figure 5 illustrates another example coating device for use with the deposition apparatus, but which falls outside the scope of the claims.

### DETAILED DESCRIPTION OF THE PREFERRED EMBODIMENT

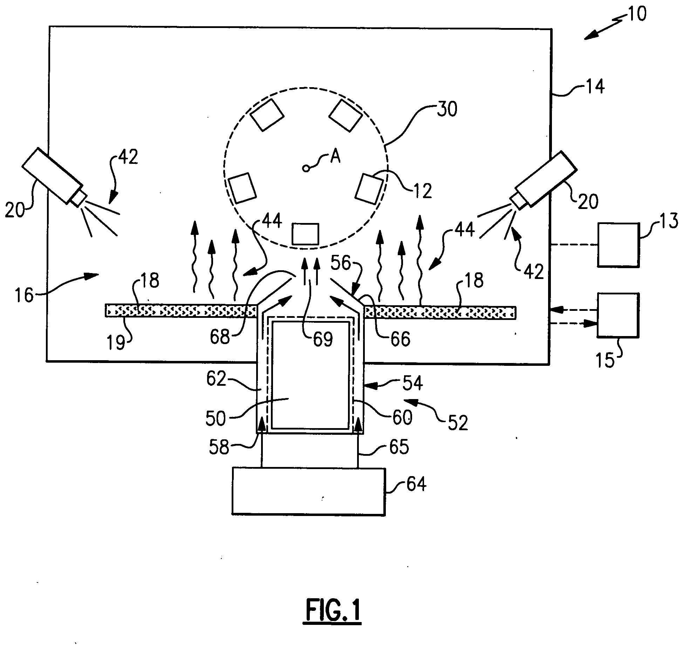

Figure 1 illustrates selected portions of an example deposition apparatus 10 for depositing a coating on one or more work pieces 12 via electron beam directed vapor deposition ("EBDVD"). The example deposition apparatus 10 is adapted for EBDVD; however, it is to be understood that other types of deposition equipment and physical vapor deposition processes may also benefit from the disclosed examples. Additionally, the work pieces 12 are not limited to any particular type. For instance, the work pieces 12 may be gas turbine engine components, such as airfoils (e.g., blades and vanes), or other components.

The type of coating deposited may be any desired coating that is suitable for vapor deposition, such as a metallic coating or a ceramic coating. In one example, the coating is a ceramic thermal barrier coating that includes gadolinia, zirconia, yttria, or combinations thereof. For instance, the ceramic is gadolinia stabilized zirconia, yttria stabilized zirconia, or a multi-layer combination. In a further example, the ceramic thermal barrier coating includes about 59wt% of gadolinia and a balance of zirconia. The term "about" as used in this description relative to compositions or other values refers to possible variation in the given value, such as normally accepted variations or tolerances in the art.

In the illustrated example, the deposition apparatus 10 includes a coating chamber 14 for containing the work pieces 12. For instance, the coating chamber 14 may be a vacuum chamber and may include various ports for evacuating the interior of the coating chamber 14 or for selectively introducing gases that are to be used in the coating process. For instance, a gas source 13 provides a desired flow of oxygen or other gas. Optionally, a pump 15 may circulate a coolant (e.g., water) through walls of the coating chamber 14 to control wall temperature.

A heating source 16 may be located within the coating chamber 14 to heat the work pieces 12 to an oxidation temperature for a pre-heating stage. For instance, the work pieces 12 may include a nickel alloy substrate and a bond coat on the substrate. The bond coat may include MCrAlY, where the M includes at least one of nickel, cobalt, iron, or a combination thereof, Cr is chromium, Al is aluminum, and Y is yttrium.

The work pieces 12 may be pre-heated at the oxidation temperature to form a thermally grown oxide on the bond coat that enhances adhesion of ceramic thermal barrier coatings to the work pieces 12.

In the disclosed example, the heating source 16 includes a media 18 that may be used to radiate heat and heat the work pieces 12 to the oxidation temperature. The media 18 may be any type of media that radiates heat. For instance, the media 18 may include particles of a ceramic material in a water-cooled tray 19. In one example, the ceramic material composition is equivalent to the composition of the coating that is to be deposited onto the work pieces 12 to avoid contaminating the work pieces 12 with foreign substances. In other examples, the heating source 16 may be a resistance heater or other type of heater.

At least one electron beam source 20, such as an electron gun, is mounted relative to the coating chamber 14 for pre-heating the media 18 and for depositing the coating. The disclosed example illustrates two electron beam sources 20, which may be used for pre-heating the media 18, applying the coating, or both. However, given this description, one of ordinary skill in the art will recognize that a single source or additional sources may be used to meet the needs of a particular application or coating process.

The work pieces 12 are mounted within a coating zone 30 in the coating chamber 14. For instance, the coating zone 30 is the spatial volume where the work pieces 12 will be coated. The work pieces 12 may be mounted in the coating zone 30 using a mounting fixture, such as a cylindrical fixture.

The electron beam sources 20 may be activated to emit electron beams 42 onto the media 18. The electron beams 42 heat the media 18 and produce radiant heat 44 that radiates toward the coating zone 30. For example, a controller (not shown) may utilize software, hardware, or both to control focus, filament current, scanning area (power density), and/or other parameters of the electron beam sources 20 along with other operations associated with the deposition apparatus 10 (e.g., gas flow) to provide a desired amount of heat before and/or during the coating process. The electron beam sources 20 may also raster relatively low current-density electron beams 42 across the work pieces 12 prior to or during coating to directly heat the work pieces 12.

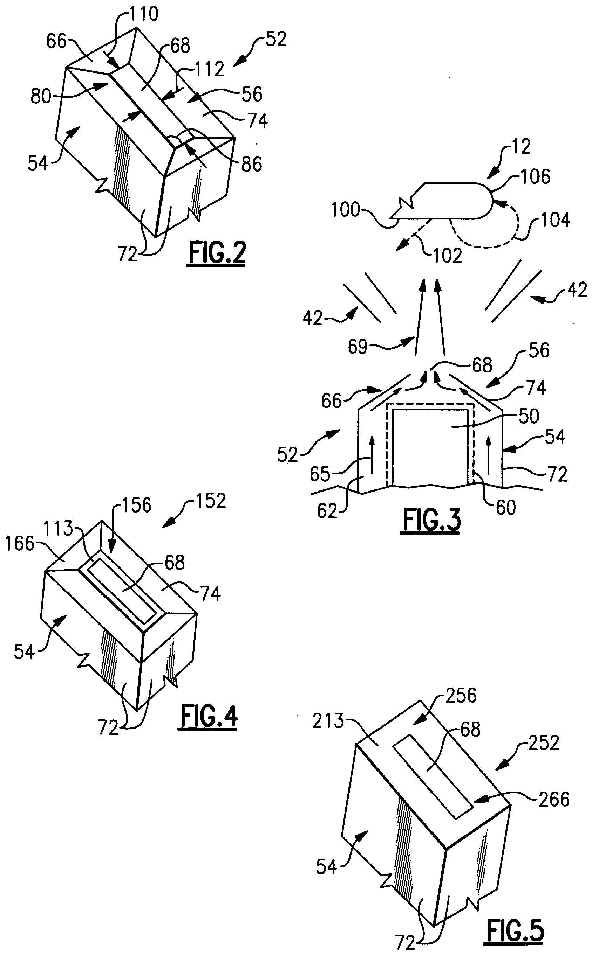

In the coating process, the electron beam sources 20 may be activated as described above to emit electron beams 42 onto an ingot 50 serving as the source material for coating the work pieces 12. The deposition apparatus 10 presents the ingot 50 into the coating chamber 14 using a coating device 52. The coating device 52 illustrated in Figure 2 does not fall within the scope of the claims. Although only one coating device 52 is shown, the coating chamber 14 may utilize multiple coating devices 52 and corresponding multiple ingots 50.

The coating device 52 includes a crucible portion 54 and a nozzle portion 56 for facilitating deposition of the coating. The crucible portion 54 includes a gas inlet port 58, a heating zone 60 for presenting the ingot 50, and a flow passage 62 exposed to the heating zone 60. The flow passage 62 is fluidly connected with the gas inlet port 58. The gas inlet port 58 may be a connector fitting or the like for connecting the coating device 52 with a gas source 64 for selectively providing a carrier gas 65, such as an inert gas.

The nozzle portion 56 includes a funnel 66 having an outlet orifice 68 fluidly connected with the flow passage 62 for jetting a coating stream 69 from the coating device 52. The coating stream 69 includes vaporized source material from the ingot 50 entrained in the carrier gas 65. As will be described in greater detail below, the carrier gas 65 flows over the ingot 50 as the ingot 50 evaporates. The carrier gas 65 entrains vaporized source coating material from the ingot 50 to produce the coating stream 69. The coating stream 69 flows through the funnel 66 and jets from the outlet orifice 68 toward the coating zone 30 (e.g., directed vapor deposition) to deposit the source coating material on the work pieces 12.

Referring also to Figure 2, the outlet orifice 68 has a rectilinear cross-section. That is, the outlet orifice 68 has a cross-sectional area formed with at least one straight line side. In the illustrated example, the outlet orifice 68 has a rectangular cross-section with four straight line sides. However, in other examples, the cross-section of the outlet orifice 68 may be another polygonal shape having any desired number of straight line sides.

The crucible portion 54 may have any suitable shape for presenting the ingot 50. In the illustrated example, the crucible portion 54 includes four planar side walls 72 (two shown) arranged in a parallelogram. In other examples, the crucible portion 54 may include fewer or additional side walls that are geometrically or non-geometrically arranged, a curved side wall, or combinations thereof.

The funnel 66 of the nozzle portion 56 may include one or more sloped walls 74 that extend between the crucible portion 54 and the outlet orifice 68. For example, there may be one sloped wall 74 corresponding to each planar side wall 72 of the crucible portion 54, a sloped wall 74 with curved corners, or a combination thereof. In the example shown, each sloped wall 74 is connected on two opposed sides to two other respective sloped walls 74, and spans between the planar side wall 72 and the outlet orifice 68. The sloped walls 74 may be planar such that the planes are angled with respect to the planar side walls 72 to form the funnel 66.

The funnel 66 is fluidly connected with the flow passage 62 of the crucible portion 54. The reduction in cross-sectional area increases flow rate and thereby "jets" the coating stream 69 from the outlet orifice 68. The jetted coating stream 69 may be aimed at a particular portion or portions of one or more of the work pieces 12 that are to be coated.

The crucible portion 54, the nozzle portion 56, or both may be formed from any suitable type of material. In one example, the crucible portion 54, the nozzle portion 56, or both are formed from a refractory material, such as a ceramic, or an alloy material that resists the temperatures generated during the coating process. In some examples, the crucible portion 54, the nozzle portion 56, or both may be cooled structures to facilitate temperature resistance.

Figure 3 illustrates an example of using the coating device 52 to facilitate coating the work piece 12. In the illustrated example, the rectilinear cross-section of the outlet orifice 68 facilitates coating transversely oriented surfaces (i.e., surfaces non-perpendicularly oriented to the flow direction of the coating stream 69) and non-line-of-sight surfaces of the work pieces 12. For instance, the straight line sides of the outlet orifice 68 meet at corners 86. The corners 86 may contribute to random collisions among the particles in the coating stream 69 from the outlet orifice 68 such that the coating stream 69 generally moves toward the coating zone 30. When the coating stream 69 impinges upon a line-of-sight surface 100 of the work piece 12, the carrier gas 65 and any undeposited ingot material may deflect off of the line-of-sight surface 100. The random collisions among the particles in the coating stream 69 randomize the direction of deflection of any undeposited ingot material. For instance, a portion of the deflected ingot material may deflect in direction 102 and another portion of the evaporated ingot material may deflect along direction 104. Thus, instead of always deflecting back toward the coating device 52, the undeposited ingot material deflects in random directions and may thereby deflect toward a transversely oriented surface or a non-line-of-sight surface, such as non-line-of-sight surface 106 of the work piece 12. The coating device 52 thereby facilitates depositing the coating on transversely oriented surfaces and non-line-of-sight surfaces.

The rectilinear cross-section of the outlet orifice 68 also provides a favorable shape of the coating stream 69. For instance, the rectilinear cross-section creates a cone-shaped flow stream that facilitates accurately directed the coating stream 69 at the work pieces 12.

Likewise, the line-of-sight surface 100 being coated may be near a corner or fillet radius, and the randomized deflection may reduce interference with the incoming coating stream 69 to facilitate coating the line-of-sight surface 100.

The coating stream 69 may also directly impinge upon and coat transversely oriented surfaces and non-line-of-sight surfaces. For instance, vaporized ingot material flowing within the coating stream 69 may flow along a curved path around an edge of the work piece 12 to impinge upon and coat a transversely oriented surface or non-line-of-sight surface that is adjacent to the edge.

Additionally, the coating device 52 may be used to facilitate forming a desired orientation of the coating on the transversely oriented surfaces and non-line-of-sight surfaces. For instance, the coating generally forms in a columnar microstructure with a columnar axis approximately parallel to the flow direction of the coating stream 69. On a line-of sight surface, the microstructural columns would be approximately perpendicular to the line-of-sight surface. Without the random collisions among the particles in the coating stream 69, the microstructural columns formed on transversely oriented surfaces would not be perpendicular to the transversely oriented surfaces. With the random collisions in the coating stream 69 though, the deflected ingot material impinges the transversely oriented surface at a steeper angle (e.g., approaching perpendicular) such that the columns would be approximately perpendicular to the surface. For example, perpendicular microstructural columns may be desirable on all surfaces for enhanced durability and strength.

The flow of coating stream 69 may be designed to achieve a desired coating effect. For instance, the example outlet orifice 68 has an aspect ratio of length 110 to width 112 that is greater than one (see Figure 2). In some examples, the aspect ratio may be designed to provide a desired shape of the coating stream 69 to produce a desired coating effect or coating orientation. Likewise, the number of straight line sides of the outlet orifice 68 or the angles of the corners 86 between the sides may be designed to influence the coating stream. Additionally, the influence of the geometry of the outlet orifice 68 may be used in combination with controlling other parameters, such as the stand-off distance between the work pieces 12 and the coating device 52, the steady state inputs of the deposition apparatus 10 (e.g., pressures, gas flows, etc.), and auxiliary jet flows to further direct the coating stream 69 or deflected undeposited ingot material, for example.

In one example, the work pieces 12 are paired turbine airfoil components, such as a pair of cast vane airfoils secured to a common platform section. The coating device 52 provides the benefit of depositing a strong and durable coating on the paired turbine airfoil components, which includes a variety of transversely oriented and non-line of sight surfaces on the common platform section and at the radius between the airfoils and the common platform section. In a further example, the coating device 52 may be used to deposit the coating on non-line-of-sight surfaces between the pair of cast vane airfoils, which may only be fractions of an inch apart. That is, the coating device 52 may be aimed such that the coating stream 69 flows between the pair of cast vane airfoils.

Figure 4 illustrates an example coating device 152 that is similar to the coating device 52 of the previous example and may be used in the deposition apparatus 10. In this disclosure, like reference numerals designate like elements where appropriate, and reference numerals with the addition of one-hundred or multiples thereof may designate modified elements. The modified elements incorporate the same benefits of the corresponding modified elements, except where stated otherwise. A nozzle portion 156 of the coating device 152 includes a funnel 166 having a top wall 113 that extends between the outlet orifice 68 and the sloped walls 74. The top wall 113 is planar and is perpendicularly oriented relative to the planar side walls 72 of the crucible portion 54.

As may be appreciated, the carrier gas 65 and entrained ingot material flowing through the flow passage 62 may impinge upon the top wall 113 before exiting through the outlet orifice 68 to produce random collisions among the particles within the coating stream 69.

Figure 5 illustrates another example coating device 252 that is similar to the coating device 52 of the previous example, but which falls outside the scope of the claims, and may be used in the deposition apparatus 10. In this example, a nozzle portion 256 of the coating device 252 includes a funnel 266 (in the sense that the carrier gas 65 and entrained ingot material will flow along a sloped path) but does not include the sloped walls 74 as in
the previous example. That is, the funnel 266 only includes a top wall 213 extending between the outlet orifice 68 and the planar side walls 72 of the crucible portion 54. The top wall 213 is may be planar and may be approximately perpendicularly oriented to the planar side walls 72. The carrier gas 65 and entrained ingot material flowing through the flow passage 62 may impinge upon the top wall 213 before exiting through the outlet orifice 68 to produce random collisions among the particles within the coating stream 69.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art. The scope of legal protection given to this disclosure can only be determined by studying the following claims.

## Claims

1. A coating device (52;152;252) for use with an electron beam vapor deposition apparatus, comprising:
a crucible portion (54) having a gas inlet port (58), a heating zone (60) for presenting a source coating material to be heated, and a flow passage (62) exposed to the heating zone (60) and fluidly connected with the inlet port (58); and
a nozzle portion (56; 156;256) including an outlet orifice (68) fluidly connected with the flow passage (62) for jetting a coating stream (69) from the coating device (52; 152;252), the outlet orifice (68) having a rectilinear cross-section, the rectilinear cross-section being polygonal, the nozzle portion (52;152;252) including a funnel (66;166;266) through which the outlet orifice (68) extends;
**characterised in that**:
the crucible portion (54) includes planar side walls (72), and the nozzle portion (156) includes a planar top wall (113) perpendicularly oriented relative to the planar side walls (72) and sloped walls (74) extending from the planar top wall (113), the outlet orifice (68) extending through the planar top wall (113).

2. The coating device as recited in claim 1, wherein the rectilinear cross-section has an aspect ratio that is greater than one.

3. The coating device as recited in claim 1 or 2, wherein the rectilinear cross-section includes at least four sides.

4. An electron beam vapor deposition apparatus (10) comprising:
a coating chamber (14);
a coating zone (30) within the coating chamber (14);
at least one electron beam source (20) for evaporating a source coating material (50);
a gas source (64) for selectively providing a carrier gas; and
a coating device as claimed in any preceding claim, the gas inlet port (58) fluidly connectable with the gas source (64), and the outlet orifice (68) for jetting a coating stream (69) of the source coating material (50) and the carrier gas toward the coating zone (30).

5. The electron beam vapor deposition apparatus as recited in claim 4, further comprising an ingot (50) as the source coating material, the ingot (50) including at least one of yttria, gadolinia, or zirconia.

6. A method for use with an electron beam vapor deposition apparatus (10), comprising:
emitting electron beams from an electron beam source (20) onto a source coating material (50) within a crucible portion (54) of a coating device (52;152;252) to evaporate the source coating material;
entraining evaporated source coating material in a carrier gas to provide a coating stream (69); and
jetting the coating stream (69) toward a coating zone (30) from an outlet orifice (68) of a nozzle portion (56;156;256) of the coating device (52;152;252), the outlet orifice (68) having a rectilinear cross-section, the rectilinear cross-section being polygonal, and wherein the crucible portion (54) includes planar side walls (72), and the nozzle portion (156) includes a planar top wall (113) perpendicularly oriented relative to the planar side walls (72) and sloped walls (74) extending from the planar top wall (113), the outlet orifice (68) extending through the planar top wall (113);
the jetting includes establishing a flow of the coating stream (69) through a funnel (66;166;266) of the nozzle portion (56; 156; 256) of the coating device (52;152;252), the funnel including the outlet orifice (68).

7. The method as recited in claim 6, wherein the entraining includes evaporating the source coating material to produce vaporized source coating material and establishing a flow of the carrier gas adjacent to the source coating material.

## Patentansprüche

1. Beschichtungsvorrichtung (52; 152; 252) zur Verwendung mit einem Elektronenstrahlverdampfer, umfassend:
einen Tiegelabschnitt (54), der eine Gaseinlassöffnung (58), eine Heizzone (60) zum Darreichen eines Ausgangsbeschichtungsmaterials, das zu erhitzen ist, und einen Strömungskanal (62), der der Heizzone (60) ausgesetzt ist und in Fluidverbindung mit der Einlassöffnung (58) steht, aufweist; und
einen Düsenabschnitt (56; 156; 256), der eine Auslassöffnung (68) umfasst, die in Fluidverbindung mit dem Strömungskanal (62) steht, um einen Beschichtungsstrom (69) von der Beschichtungsvorrichtung (52; 152; 252) auszustoßen, wobei die Auslassöffnung (68) einen geradlinigen Querschnitt aufweist, wobei der geradlinige Querschnitt polygonal ist, wobei der Düsenabschnitt (52; 152; 252) einen Trichter (66; 166; 266) umfasst, durch den die Auslassöffnung (68) verläuft;
**dadurch gekennzeichnet, dass**:
der Tiegelabschnitt (54) plane Seitenwände (72) umfasst und der Düsenabschnitt (156) eine plane obere Wand (113), die lotrecht relativ zu den planen Seitenwänden (72) ausgerichtet ist, und geneigte Wände (74), die von der planen oberen Wand (113) aus verlaufen, umfasst, wobei die Auslassöffnung (68) durch die plane obere Wand (113) verläuft.

2. Beschichtungsvorrichtung nach Anspruch 1, wobei der geradlinige Querschnitt ein Seitenverhältnis aufweist, das größer als Eins ist.

3. Beschichtungsvorrichtung nach Anspruch 1 oder 2, wobei der geradlinige Querschnitt mindestens vier Seiten umfasst.

4. Elektronenstrahlverdampfer (10), umfassend:
eine Beschichtungskammer (14);
eine Beschichtungszone (30) innerhalb der Beschichtungskammer (14) ;
mindestens eine Elektronenstrahlquelle (20) zum Verdampfen eines Ausgangsbeschichtungsmaterials (50);
eine Gasquelle (64) zum selektiven Bereitstellen eines Trägergases; und
eine Beschichtungsvorrichtung nach einem der vorstehenden Ansprüche, wobei eine Fluidverbindung zwischen der Gaseinlassöffnung (58) und der Gasquelle (64) hergestellt werden kann, und der Auslassöffnung (68) zum Ausstoßen eines Beschichtungsstroms (69) des Ausgangsbeschichtungsmaterials (50) und des Trägergases in Richtung zur Beschichtungszone (30) ist.

5. Elektronenstrahlverdampfer nach Anspruch 4, ferner umfassend einen Rohblock (50) als das Ausgangsbeschichtungsmaterial, wobei der Rohblock (50) mindestens eines aus Yttriumoxid, Gadoliniumoxid oder Zirconiumoxid umfasst.

6. Verfahren zur Verwendung mit einem Elektronenstrahlverdampfer (10), umfassend:
Ausgeben von Elektronenstrahlen von einer Elektronenstrahlquelle (20) auf ein Ausgangsbeschichtungsmaterial (50) innerhalb eines Tiegelabschnitts (54) einer Beschichtungsvorrichtung (52; 152; 252), um das Ausgangsbeschichtungsmaterial zu verdampfen;
Mitreißen von verdampftem Ausgangsbeschichtungsmaterial in einem Trägergas, um einen Beschichtungsstrom (69) bereitzustellen; und
Ausstoßen des Beschichtungsstroms (69) in Richtung auf eine Beschichtungszone (30) aus einer Auslassöffnung (68) eines Düsenabschnitts (56; 156; 256) der Beschichtungsvorrichtung (52; 152; 252), wobei die Auslassöffnung (68) einen geradlinigen Querschnitt aufweist, wobei der geradlinige Querschnitt polygonal ist, und wobei der Tiegelabschnitt (54) plane Seitenwände (72) umfasst und der Düsenabschnitt (156) eine plane obere Wand (113), die lotrecht relativ zu den planen Seitenwänden (72) ausgerichtet ist, und geneigte Wände (74), die von der planen oberen Wand (113) aus verlaufen, umfasst, wobei die Auslassöffnung (68) durch die plane obere Wand (113) verläuft;
wobei das Ausstoßen das Herstellen einer Strömung des Beschichtungsstroms (69) durch einen Trichter (66; 166; 266) des Düsenabschnitts (56; 156, 256) der Beschichtungsvorrichtung (52; 152; 252) umfasst, wobei der Trichter die Auslassöffnung (68) umfasst.

7. Verfahren nach Anspruch 6, wobei das Mitreißen das Verdampfen des Ausgangsbeschichtungsmaterials, um verdampftes Ausgangsbeschichtungsmaterial herzustellen, und das Herstellen eines Stroms des Trägergases angrenzend an das Ausgangsbeschichtungsmaterial, umfasst.

## Revendications

1. Dispositif de revêtement (52 ; 152 ; 252) à utiliser avec un appareil de dépôt en phase vapeur par faisceau d'électrons, comprenant :
une portion de creuset (54) ayant une lumière d'admission de gaz (58), une zone de chauffage (60) destinée à présenter un matériau de revêtement source à chauffer, et un passage d'écoulement (62) exposé à la zone de chauffage (60) et raccordé fluidiquement à la lumière d'admission (58) ; et
une portion de buse (56 ; 156 ; 256) incluant un orifice de refoulement (68) raccordé fluidiquement au passage d'écoulement (62) pour éjecter un courant de revêtement (69) depuis le dispositif de revêtement (52 ; 152 ; 252), l'orifice de refoulement (68) ayant une section transversale rectiligne, la section transversale rectiligne étant polygonale, la portion de buse (52 ; 152 ; 252) incluant un entonnoir (66 ; 166 ; 266) à travers lequel s'étend l'orifice de refoulement (68) ;
**caractérisé en ce que** :
la portion de creuset (54) inclut des parois latérales planes (72), et la portion de buse (156) inclut une paroi haute plane (113) orientée perpendiculairement par rapport aux parois latérales planes (72) et des parois pentues (74) s'étendant depuis la paroi haute plane (113), l'orifice de refoulement (68) s'étendant à travers la paroi haute plane (113).

2. Dispositif de revêtement selon la revendication 1, dans lequel la section transversale rectiligne a un rapport de côté qui est plus grand que un.

3. Dispositif de revêtement selon la revendication 1 ou 2, dans lequel la section transversale rectiligne inclut au moins quatre côtés.

4. Appareil de dépôt en phase vapeur par faisceau d'électrons (10) comprenant :
une chambre de revêtement (14) ;
une zone de revêtement (30) au sein de la chambre de revêtement (14) ;
au moins une source de faisceau d'électrons (20) destinée à évaporer un matériau de revêtement source (50) ;
une source de gaz (64) destinée à fournir sélectivement un gaz vecteur ; et
un dispositif de revêtement tel que revendiqué dans une quelconque revendication précédente, la lumière d'admission de gaz (58) pouvant être raccordée fluidiquement à la source de gaz (64), et le orifice de refoulement (68) pour éjecter un courant de revêtement (69) du matériau de revêtement source (50) et le gaz vecteur vers la zone de revêtement (30).

5. Appareil de dépôt en phase vapeur par faisceau d'électrons selon la revendication 4, comprenant en outre un lingot (50) en tant que matériau de revêtement source, le lingot (50) incluant au moins l'un parmi l'oxyde d'yttrium, l'oxyde de gadolinium, ou la zircone.

6. Procédé à utiliser avec un appareil de dépôt en phase vapeur par faisceau d'électrons (10), comprenant :
l'émission de faisceaux d'électrons à partir d'une source de faisceau d'électrons (20) sur un matériau de revêtement source (50) au sein d'une portion de creuset (54) d'un dispositif de revêtement (52 ; 152 ; 252) pour évaporer le matériau de revêtement source ;
l'entraînement de matériau de revêtement source évaporé dans un gaz vecteur pour fournir un courant de revêtement (69) ; et
l'éjection du courant de revêtement (69) vers une zone de revêtement (30) depuis un orifice de refoulement (68) d'une portion de buse (56 ; 156 ; 256) du dispositif de revêtement (52 ; 152 ; 252), l'orifice de refoulement (68) ayant une section transversale rectiligne, la section transversale rectiligne étant polygonale, et dans lequel la portion de creuset (54) inclut des parois latérales planes (72), et la portion de buse (156) inclut une paroi haute plane (113) orientée perpendiculairement par rapport aux parois latérales planes (72) et des parois pentues (74) s'étendant depuis la paroi haute plane (113), l'orifice de refoulement (68) s'étendant à travers la paroi haute plane (113) ;
l'éjection inclut l'établissement d'un écoulement du courant de revêtement (69) à travers un entonnoir (66 ; 166 ; 266) de la portion de buse (56 ; 156 ; 256) du dispositif de revêtement (52 ; 152 ; 252), l'entonnoir incluant l'orifice de refoulement (68).

7. Procédé selon la revendication 6, dans lequel l'entraînement inclut l'évaporation du matériau de revêtement source pour produire un matériau de revêtement source vaporisé et établir un écoulement du gaz vecteur adjacent au matériau de revêtement source.
